Europäisches Patentamt

European Patent Office

Office européen des brevets

(19)

(11) **EP 0 684 455 B1**

(12) **FASCICULE DE BREVET EUROPEEN**

(45) Date de publication et mention
de la délivrance du brevet:
**06.05.1999 Bulletin 1999/18**

(51) Int Cl.6: **G01D 5/244**, H03K 5/00

(21) Numéro de dépôt: **95401212.6**

(22) Date de dépôt: **24.05.1995**

(54) **Circuit de multiplication de résolution**

Interpolationsschaltung

Interpolation circuit

(84) Etats contractants désignés:
**DE ES FR GB IT SE**

(30) Priorité: **27.05.1994 US 250190**

(43) Date de publication de la demande:
**29.11.1995 Bulletin 1995/48**

(73) Titulaire: **SNR ROULEMENTS
F-74000 Annecy (FR)**

(72) Inventeurs:
• **Santos, A. John, Cabinet Ballot-Schmit
F-75116 Paris (FR)**
• **LaCroix, Mark E., Cabinet Ballot-Schmit
F-75116 Paris (FR)**

(74) Mandataire: **Ballot, Paul Denis Jacques et al
Cabinet Ballot-Schmit,
7, rue Le Sueur
75116 Paris (FR)**

(56) Documents cités:
**EP-A- 0 311 947          EP-A- 0 478 394**

• **PATENT ABSTRACTS OF JAPAN vol. 010 no.
039 (E-381) ,15 Février 1986 & JP-A-60 194820
(MATSUSHITA DENKI SANGYO KK) 3 Octobre
1985,**
• **PATENT ABSTRACTS OF JAPAN vol. 005 no.
192 (E-085) ,8 Décembre 1981 & JP-A-56 115024
(NEC CORP) 10 Septembre 1981,**

## Description

ARRIERE PLAN DE L'INVENTION

La présente invention concerne d'une façon générale des circuits d'amélioration de résolution et, plus particulièrement, des circuits pour multiplier la résolution de signaux de sortie de capteurs de vitesse et de déplacement.

Traditionnellement, une augmentation de résolution avec des capteurs de vitesse ou de déplacement a été obtenue par multiplication mécanique. Par exemple, si des pôles magnétiques et des capteurs numériques à effet-Hall sont utilisés pour produire des informations de position sous forme de points de données, des pôles magnétiques ou des capteurs additionnels peuvent être ajoutés entre des pôles magnétiques ou des capteurs initiaux afin d'obtenir une division de l'espace plus fine entre des points de données. Une telle augmentation de résolution est limitée par des impératifs de place disponible pour des capteurs et pôles additionnels ainsi que par les coûts associés des composants additionnels.

En addition aux problèmes se rapportant aux impératifs de place disponible et aux coûts, une dérive intrinsèque des points de commutation des capteurs numériques produit une imprécision dans le système de captage, en particulier puisque tous les capteurs ne peuvent pas dériver de la même manière en fonction du temps, de la température et d'autres conditions. Des variations d'entrefer, de gain de capteur, d'amplitude de signal et de polarisation du champ magnétique en cours de fonctionnement peuvent également réduire la précision du système de captage.

Un autre procédé connu pour augmenter la résolution pour les capteurs de vitesse ou de déplacement consiste à comparer des signaux provenant de deux ou plus de deux capteurs afin de produire électroniquement des points de données intermédiaires. Par exemple, lorsque deux capteurs sont positionnés de façon à produire des signaux qui sont déphasés de 90 degrés, les signaux peuvent être combinés avec des pourcentages différents de façon à créer des points de données additionnels par interpolation. Cependant, les points intermédiaires ne seront pas placés avec précision si les signaux des deux capteurs ne dérivent pas de la même manière.

Le document "PATENT ABSTRACTS OF JAPAN", vol.10, no. 39 (E-381), 15 Février 1986 & JP-A-60 194820 (MATSUSHITA DENKI SANGYO K.K.)" décrit un multiplicateur de fréquence pour améliorer la résolution d'un seul capteur.

Ce qui précède illustre des limitations connues qui existent dans les procédés et dispositifs connus à l'heure actuelle. En conséquence il est évident qu'il serait avantageux de trouver une variante conçue pour éliminer une ou plusieurs des limitations définies ci-dessus. En correspondance, il est prévu une solution appropriée comportant des particularités qui vont être décrites de façon plus détaillée dans la suite.

SOMMAIRE DE L'INVENTION

Selon l'invention, il est proposé la création d'un circuit de multiplication de résolution utilisable avec plusieurs capteurs analogiques ayant une position de déphasage électrique prédéterminée. Des moyens de maintien de maxima maintiennent des tensions maximales précédentes de signaux provenant des capteurs analogiques respectifs et des moyens de maintien de minima maintiennent des tensions minimales de signaux provenant des capteurs analogiques respectifs. Des moyens de génération de seuils produisent plusieurs tensions de seuil à partir des tensions maximales et minimales précédentes provenant des capteurs analogiques respectifs. Des moyens de comparaison de tensions comparent indépendamment les signaux provenant des capteurs analogiques avec les tensions de seuil respectives afin de produire des séquences de transitions de sortie. Des moyens de combinaison combinent les transitions de sortie de telle sorte que chaque séquence de transitions de sortie provenant de chaque capteur analogique se produise entre des séquences de transition de sortie provenant des autres capteurs analogiques.

Les aspects de l'invention ressortiront de la description détaillée de l'invention qui va suivre, lorsqu'elle est considérée en relation avec les dessins ci-joints.

BREVE DESCRIPTION DES FIGURES DES DESSINS

La figure 1 est un schéma à blocs représentant une réalisation de la présente invention, comportant une logique facultative de rétablissement de maxima indiquée en trait mixte ;
la figure 2 est une représentation graphique de formes d'ondes en fonction du temps correspondant au schéma à blocs de la figure 1 ; et
la figure 3 est une représentation schématique montrant une application d'un circuit spécifique correspondant au schéma à blocs de la figure 1.

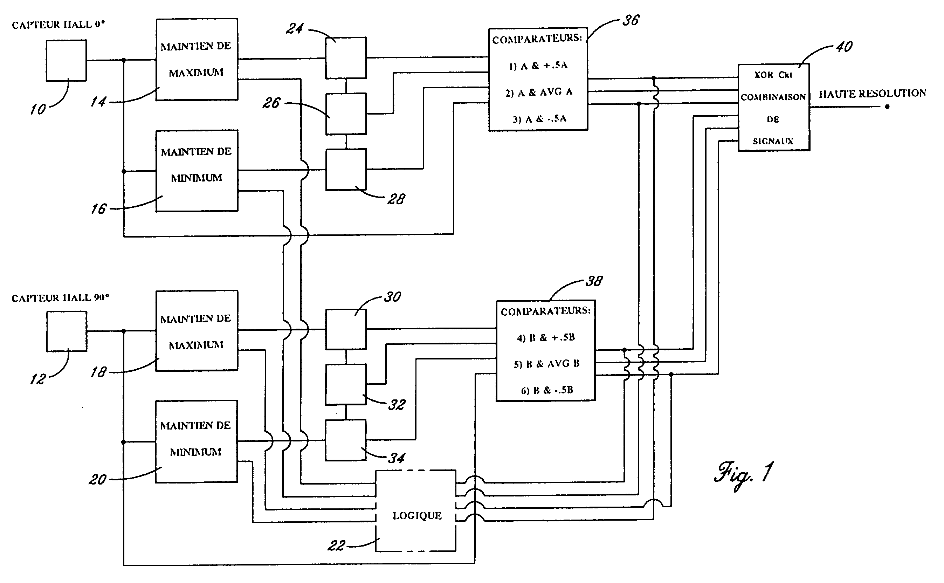

En référence maintenant aux dessins, le schéma à blocs de la figure 1 représente deux capteurs analogiques 10 et 12, par exemple des capteurs à effet Hall, qui sont disposés avec un déphasage électrique de valeur prédéterminée en degrés. Sur le schéma à blocs, le déphasage électrique prédéterminé est de 90 degrés et les capteurs analogiques 10 et 12 sont désignés respectivement par Hall A et Hall B. D'autres types de capteurs analogiques et de positionnement peuvent être utilisés avec un effet semblable.

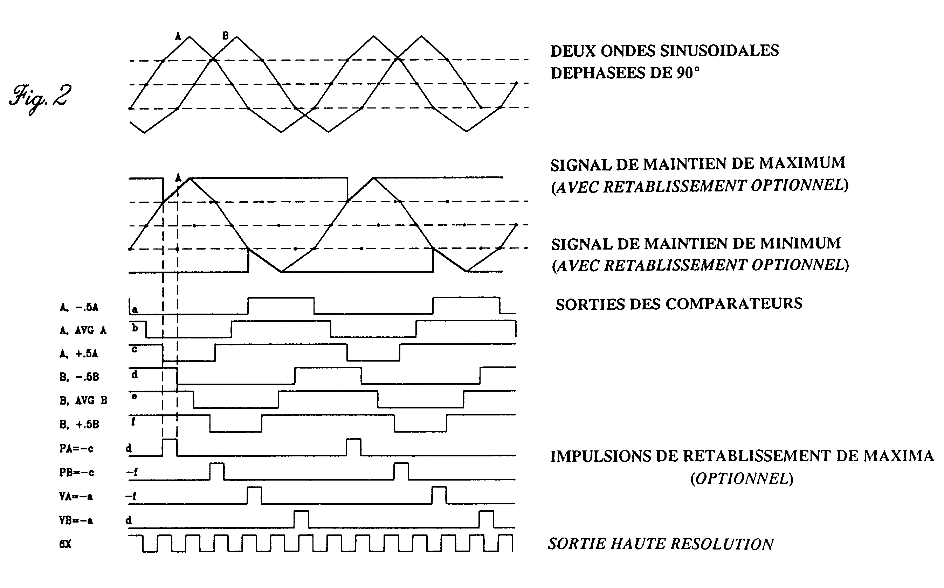

Des signaux des capteurs analogiques 10 et 12 peuvent être, par exemple, des ondes sinusoïdales A et B ayant un angle de phase de 90 degrés comme indiqué en haut de la figure 2. Un moyen de maintien de maxima 14 et un moyen de maintien de minima 16 captent respectivement des tensions maximale et minimale précédentes du signal A et maintiennent ces tensions comme des valeurs de référence. De façon analogue, un moyen de maintien de maxima 18 et un moyen de maintien de minima 20 captent respectivement des tensions maximale et minimale précédentes du signal B et maintiennent ces tensions comme des valeurs de référence.

Une logique de rétablissement de maxima 22 prévue facultativement peut être utilisée pour décharger les tensions de référence avant la fin de chaque période (comme indiqué sur la figure 2) afin de permettre un rétablissement des tensions de référence maxima et minima. Bien que cela ne soit pas nécessaire pour la mise en oeuvre de la présente invention, la logique de rétablissement de maxima 22 peut être prévue additionnellement afin de produire une compensation constante de changements de gain ou d'amplitude du signal A et du signal B, en augmentant ainsi la précision du système de captage lorsque la tension du signal A ou du signal B dérive vers le haut ou vers le bas.

Des moyens de division de tensions 24, 26 et 28 divisent les tensions de référence du signal A de façon à produire des tensions de seuil correspondant à la moyenne des tensions maximales et minimales du signal A, à mi-chemin entre cette valeur moyenne et la tension maximale, et à mi-chemin entre cette valeur moyenne et la tension minimale. De façon analogue, des moyens de division de tension 30, 32 et 34 produisent des tensions de seuil correspondant à la moyenne des tensions maximales et minimales du signal B, à mi-chemin entre cette valeur moyenne et la tension maximale, et à mi-chemin entre cette valeur moyenne et la tension minimale.

Les tensions de seuil produites à partir du signal A sont appliquées à des comparateurs 36 de façon à produire des signaux de sortie a, b, c indiqués sur la figure 2. De façon analogue, les tensions de seuil produites à partir du signal B sont appliquées à des comparateurs 38 pour produire des signaux de sortie d, e, f. Un circuit OU exclusif 40 combine les signaux de sortie des comparateurs 36 et 38 pour produire le signal de sortie de haute résolution représenté en bas sur la figure 2 et qui a une résolution égale à six fois celle du capteur analogique 10 sans les avantages de la présente invention.

La logique facultative 22 de rétablissement de maxima combine les signaux de sortie des comparateurs 36 et 38 pour produire des impulsions de rétablissement de maxima PA, PB, VA et VB représentées sur la figure 2. Par exemple, les impulsions de rétablissement de maxima PA, PB, VA et VB peuvent correspondre respectivement à une combinaison logique ET de c inversé ET d, de c inversé ET f inversé, de a ET f inversé, et de a ET d, afin de décharger les valeurs de référence de maxima et de minima au moment où celles-ci sont finalement nécessaires avant les nouvelles tensions maximales et minimales. En variante, le point de décharge peut être réglé à un instant ultérieur, plus rapproché du maximum ou du minimum suivant.

Une tension de maintien de maxima établie dans le condensateur 50 est maintenue comme une tension de réaction à l'entrée d'inversion de l'amplification 44 par l'intermédiaire d'un suiveur de tension 48 et d'une résistance 62. Lorsque le signal provenant du capteur analogique 10 est appliqué à l'entrée de non-inversion de l'amplificateur 44 par l'intermédiaire de la résistance 42, le signal de sortie de l'amplificateur 44 charge le condensateur 50 par l'intermédiaire d'une diode 46 de telle sorte que la tension de charge du condensateur ne soit jamais inférieure à la tension d'entrée au capteur. La diode 46 permet de charger le condensateur 50 seulement de manière que les maxima soient maintenus.

Une tension de maintien de minima établie dans le condensateur 60 est maintenue comme une tension de réaction à l'entrée d'inversion de l'amplificateur 54 par l'intermédiaire d'un suiveur de tension 58 et d'une résistance 64. Lorsque le signal provenant du capteur analogique 10 est appliqué à l'entrée de non-inversion de l'amplificateur 54 par l'intermédiaire de la résistance 52, le signal de sortie de l'amplificateur 54 charge le condensateur 60 par l'intermédiaire d'une diode 56 de telle sorte que la tension de charge du condensateur ne soit jamais supérieure à la tension d'entrée au capteur. La diode 56 permet de charger le condensateur 60 seulement de manière que les minima soient maintenus.

Les moyens de division de tension 24, 26 et 28 comprennent quatre résistances de 1K 66, 68, 70, 72 d'une précision de un pour cent qui sont connectées en série. Une tension de sortie prise entre les résistances 68 et 70 correspond à la valeur moyenne (médiane) des tensions de référence du moyen de maintien de maxima 14 et du moyen de maintien de minima 16 et elle est appliquée au comparateur 76. Une tension de sortie prise entre les résistances 66 et 68 correspond à une valeur située à mi-chemin entre cette valeur moyenne et la tension de référence du moyen de maintien de maxima 14 et elle est appliquée au comparateur 74. Une tension de sortie prise entre les résistances 70 et 72 a une valeur située à mi-chemin entre cette valeur moyenne et la tension de référence du moyen de maintien de minima 16 et elle est appliquée au comparateur 78.

Le signal A est appliqué à l'autre entrée des comparateurs 74, 76 et 78 par l'intermédiaire respectivement de résistance de 1K 80, 82, 84. Des résistances de réaction à hystérésis 86, 88 et 90, ayant des valeurs respectives de 120K, 100K et 120K, ainsi que des résistances de travail de 10K, 92, 94 et 96, complètent les composants des comparateurs 36 de la figure 1. Le signal de sortie du comparateur 74 se présente comme le signal de sortie c de la figure 2, le signal de sortie du comparateur 76 se présente comme le signal de sortie b de la figure 2, et le signal de sortie du comparateur 78 se présente comme le signal de sortie a de la figure 2.

Le signal B provenant du capteur analogique 12 est traité indépendamment d'une manière semblable à ce qui vient d'être décrit en ce qui concerne le signal A. Une tension de maintien de crête établie pour le condensateur 106 est maintenue comme une tension de réaction à l'entrée d'inversion de l'amplificateur 100 par l'intermédiaire du suiveur de tension 104 et de la résistance 118. Quand le signal provenant du capteur analogique 12 est appliqué à l'entrée de non-inversion de l'amplificateur 100 par l'intermédiaire de la résistance 98, la tension de sortie de l'amplificateur 100 charge le condensateur 106 par l'intermédiaire d'une diode 102 de telle sorte que la tension de charge du condensateur ne soit jamais inférieure à la tension d'entrée au capteur. La diode 102 permet de charger le condensateur 106 seulement de telle sorte que des maxima soient maintenus.

Une tension de maintien de minima établie pour le condensateur 116 est maintenue comme une tension de réaction à l'entrée d'inversion de l'amplificateur 110 par l'intermédiaire du suiveur de tension 114 et de la résistance 120. Quand le signal provenant du capteur analogique 12 est appliqué à l'entrée de non-inversion de l'amplificateur 110 par l'intermédiaire d'une résistance 108, la tension de sortie de l'amplificateur 110 charge le condensateur 116 par l'intermédiaire d'une diode 112 de telle sorte que la tension de charge du condensateur ne soit jamais supérieure à la tension d'entrée au capteur. La diode 112 permet de charger le condensateur 106 seulement de telle sorte que des minima soient maintenus.

Les moyens de division de tensions 30, 32 et 34 comprennent quatre résistances de 1K 122, 124, 126 et 128, d'une précision de un pour cent, qui sont connectées en série. Une tension de sortie entre les résistances 124 et 126 correspond à la valeur moyenne des tensions de référence du moyen de maintien de maxima 18 et du moyen de maintien de minima 20 et elle est appliquée au comparateur 132. Une tension de sortie entre les résistances 122 et 124 à une valeur située à mi-chemin entre cette valeur moyenne et la tension de référence du moyen de maintien de maxima 18 et elle est appliquée au comparateur 130. Une tension de sortie prise entre les résistances 126 et 128 a une valeur située à mi-chemin entre cette valeur moyenne et la tension de référence du moyen de maintien de minima 20 et elle est appliquée au comparateur 134.

Le signal B est appliqué à l'autre entrée des comparateurs 130, 132 et 134 respectivement par l'intermédiaire des résistances de 1K 136, 138 et 140. Des résistances de réaction à hystérésis 142, 144 et 146 ayant des valeurs respectives de 120K, 100K et 120K, ainsi que des résistances de travail de 10K 148, 150 et 152 complètent les composants des comparateurs 38 de la figure 1. Le signal de sortie du comparateur 130 se présente comme le signal de sortie f de la figure 2, le signal de sortie du comparateur 132 se présente comme le signal de sortie e de la figure 2, et le signal de sortie du comparateur 134 se présente comme le signal de sortie d de la figure 2.

Les signaux de sortie a et c sont appliqués à la porte OU exclusif 154, les signaux de sortie d et f sont appliqués à la porte OU exclusif 156 et les signaux de sortie b et e sont appliqués à la porte OU exclusif 158. Les signaux de sortie de la porte OU exclusif 154 et de la porte OU exclusif 156 sont appliqués à la porte OU exclusif 160 et les signaux de sortie de la porte OU exclusif 158 et de la porte OU exclusif 160 sont appliqués à la porte OU exclusif 162. Le signal de sortie de la porte OU exclusif 162 est le signal de sortie de haute résolution désirée.

La logique facultative 22 de rétablissement de maxima comprend une porte OU exclusif 164 et une porte OU exclusif 166 qui inversent respectivement les signaux de sortie a et d, ainsi que des portes ET 168, 170, 172 et 174. Les signaux de sortie de la porte OU exclusif 164 et le signal de sortie d sont soumis à une combinaison logique ET par la porte ET 168 de façon à produire une impulsion de rétablissement VA. Les signaux de sortie de la porte OU exclusif 164 et de la porte OU exclusif 166 sont soumis à une combinaison logique ET par la porte ET 170 de façon à produire une impulsion de rétablissement VB. Le signal de sortie de la porte OU exclusif 166 et le signal de sortie a sont soumis à une combinaison logique ET par la porte ET 172 de façon à produire une impulsion de rétablissement PA. Egalement les signaux de sortie c et d sont soumis à une combinaison logique ET par la porte ET 174 de façon à produire une impulsion de rétablissement PB.

Les impulsions de rétablissement VA, VB, PA, PB sont appliquées respectivement à des commutateurs analogiques 176, 178, 180 et 182. Comme indiqué sur la figure 2, les impulsions de rétablissement font en sorte que les commutateurs produisent une charge et une décharge d'un condensateur approprié avec des valeurs égales à la tension du signal A ou du signal B.

Les résistances 66, 68, 70 et 72 de valeurs égales sont sélectionnées en correspondance à la forme d'onde sinusoïdale représentée pour les signaux A et B, définis de façon à produire des points de données qui sont uniformément espacés dans le temps. Ainsi les trois tensions de seuil produisent des transitions de sortie correspondant respectivement à 0, 30, 150, 180, 210 et 330 degrés électriques. Les résistances 122, 124, 126 et 128 produisent des transitions de sortie correspondant respectivement à 60, 90, 120, 240, 270 et 300. Lorsque les signaux A et B ont une forme différente, les valeurs relatives desdites résistances peuvent être réglées pour faire en sorte que les points de données résultants soient uniformément espacés dans le temps.

Il est important que le signal A et le signal B soient traités indépendamment de telle sorte que la séquence de transitions de sortie résultant du signal A se produise (dans le temps) entre des séquences de transitions de sortie résultant du signal B. Il en résulte que, lorsque les signaux A et B sont soumis à une dérive de gain ou à un décalage d'une manière inégale ou opposée, les transitions de signaux de sortie restent espacées d'intervalles égaux.

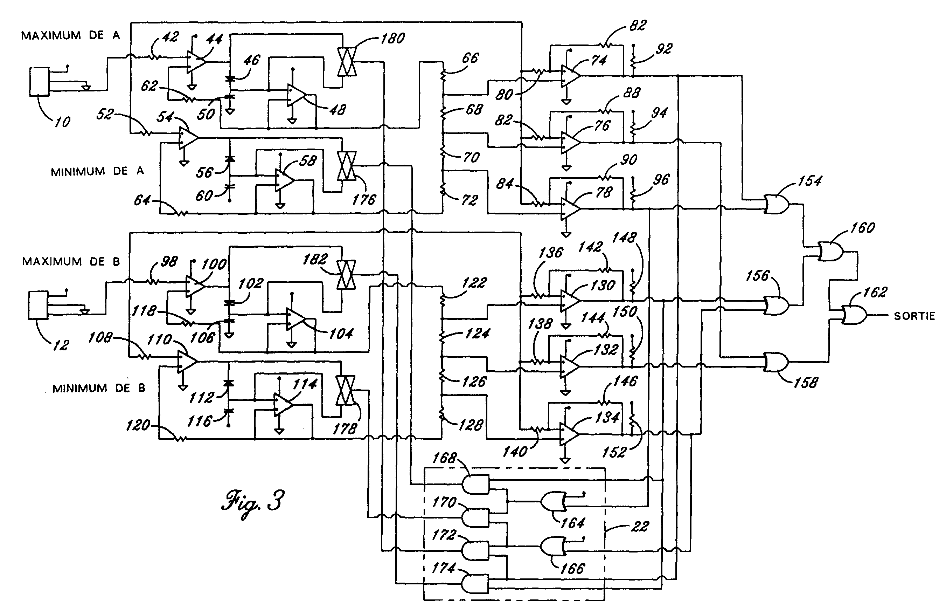

Dans l'application particulière représentée sur la figure 3, les capteurs analogiques appropriés 10 et 12 peuvent être du type à effet Hall, par exemple, avec des signaux de sortie de 0,5 à 4,0 volts de crête-à-crête, et les condensateurs 50, 60, 106 et 116 peuvent avoir chacun une capacité de 3,3 microfarads. Les amplificateurs 44, 54, 100 et 110 et les suiveurs de tension 48, 58, 104 et 114 peuvent être formés avec des circuits LM324 standard ; les commutateurs 176, 178, 180 et 182 peuvent être formés avec un circuit CD4016 standard ; et les comparateurs 74, 76, 78, 130, 132 et 134 peuvent être formés avec des circuits LM339 standard. Ces composants sont commodément disponibles à la société "National Semi-conducteur Corporation" de Santa Clara, Californie, et à d'autres sources.

Au lieu de produire trois tensions de seuil, le circuit de multiplication de résolution de la présente invention peut produire deux, quatre ou un autre nombre de tensions de seuil par division des tensions maximales et minimales précédentes et par maintien desdites valeurs en vue d'une comparaison avec le signal provenant du capteur analogique respectif. Si seulement deux tensions de seuil sont utilisées, par exemple, les deux capteurs analogiques multiplieraient par quatre la résolution initiale. Si quatre tensions de seuil sont utilisées, les deux capteurs analogiques multiplieraient par huit la résolution initiale.

Le nombre de capteurs analogiques n'est pas limité aux deux capteurs analogiques représentés sur les figures 1 à 3. Par exemple, trois capteurs analogiques peuvent être utilisés avec une séparation électrique prédéterminée correspondant à soixante degrés électriques. Plus généralement, la séparation en degrés électriques peut être représentée par 180/N plus 180n, où N désigne le nombre de capteurs analogiques et n est un nombre entier ou nul. En conséquence, un nombre quelconque de capteurs analogiques peuvent être répartis le long du trajet des signaux pour la mise en oeuvre de la présente invention. Le trajet des signaux peut être annulaire, comme avec un anneau de codeur magnétique tournant, ou bien il peut être linéaire.

Les transitions de sorties produites par la réalisation particulière représentée sur la figure 3, avec trois tensions de seuil engendrées par deux capteurs analogiques pour un déphasage de 90 degrés électriques, se manifestent à 0, 30, 150, 180, 210 et 330 degrés électriques. Si deux tensions de seuil sont engendrées par deux capteurs analogiques avec une séparation de 90 degrés électriques, les transitions de sortie se manifestent à 22.5, 157.5, 202.5 et 337.5 degrés électriques. D'autres transitions de sortie sont produites si les capteurs analogiques et tensions de seuil additionnels sont utilisés.

Il ressort de la description qui précède que la présente invention permet une multiplication de résolution de signaux de sortie de capteurs de vitesse et de déplacement sans utilisation de capteurs ou pôles magnétiques additionnels. Du fait que des capteurs analogiques sont utilisés, on évite les problèmes se posant lors d'une dérive de points de commutation de capteurs numériques. Même si le gain ou l'amplitude des signaux provenant des capteurs dérivent mutuellement, la présente invention produit une compensation constante pour obtenir en toute sécurité une indication précise de vitesse ou de déplacement.

## Revendications

1. Circuit de multiplication de résolution utilisable avec une pluralité de capteurs (10, 12) analogiques ayant une position en déphasage électrique de valeur prédéterminée, le circuit comprenant :

   - une pluralité de moyens (14, 18) de maintien de maxima, chaque moyen de maintien de maxima servant à maintenir une tension maximale précédente d'un signal provenant du capteur analogique respectif ;
   - une pluralité de moyens (16, 20) de maintien de minima, chaque moyen de maintien minima servant à maintenir une tension minimale précédente d'un signal provenant du capteur analogique respectif ;
   - des moyens (24, 26, 28, 30, 32, 34) générateurs de seuils pour produire indépendamment une pluralité de tensions de seuil à partir des tensions maximale et minimale précédentes des capteurs analogiques respectifs ;
   - des moyens (36, 38) de comparaison de tensions pour comparer indépendamment les signaux provenant des capteurs (10, 12) analogiques avec les tensions de seuil respectives, afin de produire des séquences de transitions de sortie ; et
   - des moyens (40) de combinaison pour combiner les transitions de sortie de telle sorte que chaque séquence de transition de sortie provenant de chaque capteur analogique se produise entre des séquences provenant des autres capteurs analogiques.

2. Circuit de multiplication de résolution selon la revendication 1, dans lequel la position en déphasage électrique de valeur prédéterminée des capteurs analogiques est fonction du nombre de capteurs analogiques, le déphasage en degrés électriques étant représenté par :

$$180/N + 180n$$

où N désigne le nombre de capteurs analogiques et n un nombre entier ou nul.

3. Circuit de multiplication de résolution selon la revendication 1, où le nombre de capteurs analogiques est de trois et la position prédéterminée en déphasage électrique des capteurs analogiques est de 60 degrés électriques.

4. Circuit de multiplication de résolution selon la revendication 1, dans lequel le nombre de capteurs analogiques est de deux, et la position prédéterminée en déphasage électrique des capteurs analogiques (10 et 12) est de 90 degrés électriques.

5. Circuit de multiplication de résolution selon la revendication 4, dans lequel les premiers moyens (24, 26 et 28) et les seconds moyens (30, 32 et 34) générateurs de seuil produisent chacun, par division des tensions maximale et minimale précédentes respectivement du premier et du second capteurs analogiques, trois tensions de seuil, une correspondant à la valeur moyenne des tensions maximale et minimale précédentes du signal provenant du capteur analogique respectif, une étant située à mi-chemin entre ladite valeur moyenne et la tension maximale précédente respective, et une étant située à mi-chemin entre ladite valeur moyenne et la tension minimale précédente respective.

6. Circuit de multiplication de résolution selon la revendication 5, comprenant :

- un premier moyen (14) de maintien de maxima pour maintenir une tension maximale précédente d'un signal (A) provenant du premier capteur analogique (10) ;
- un premier moyen (16) de maintien de minima pour maintenir une tension minimale précédente du signal (A) provenant du premier capteur analogique (10);
- des premiers moyens (24, 26, 28) générateurs de seuil pour produire trois tensions de seuil pour la valeur moyenne des tensions maximale et minimale précédentes du signal provenant du premier capteur analogique, pour une valeur située à mi-chemin entre cette valeur moyenne et la tension maximale précédente, et pour une valeur située à mi-chemin entre cette valeur moyenne et la tension minimale précédente ;
- un premier moyen (36) de comparaison de tension pour comparer le signal (A) provenant du premier capteur analogique (10) avec les trois tensions de seuil afin de produire des transitions de sortie pour 0, 30, 150, 180, 210 et 330 degrés électriques ;
- un second moyen (18) de maintien de maxima pour maintenir une tension maximale précédente d'un signal (B) provenant du second capteur analogique (12);

- un second moyen (20) de maintien de minima pour maintenir une tension minimale précédente d'un signal (B) provenant du second capteur analogique (12) ;
- des seconds moyens (30, 32, 34) générateurs de seuil pour produire trois tensions de seuil respectivement pour la moyenne des tensions maximale et minimale précédentes du second capteur analogique, pour une valeur située à mi-chemin entre ladite valeur moyenne et la tension maximale précédente, et pour une valeur située à mi-chemin entre ladite valeur moyenne et la tension minimale précédente ;
- un second moyen de comparaison (38) de tension pour comparer le signal (B) provenant du second capteur analogique (12) avec les trois tensions de seuil afin de produire des transitions de sortie pour 60, 90, 120, 240, 270 et 300 degrés électriques ; et
- des moyens de combinaison pour combiner les transitions de sortie du premier (36) et du second (38) moyens de comparaison de tension de telle sorte qu'un signal de sortie soit produit avec des transitions de sortie pour 0, 30, 60, 90, 120, 150, 180, 210, 240, 270, 300 et 330 degrés électriques.

7. Circuit de multiplication des résolutions selon la revendication 4, dans lequel les moyens générateurs de seuil produisent chacun deux tensions de seuil, une correspondant à la valeur moyenne des tensions maximale et minimale précédentes du signal provenant du capteur analogique respectif plus 38 pour cent de la différence entre cette valeur moyenne et la tension maximale précédente respective et l'autre correspondant à cette valeur moyenne moins 38 pour cent de la différence entre cette valeur moyenne et la tension minimale précédente respective.

8. Circuit de multiplication de résolution selon la revendication 7, comprenant :

- un premier moyen de maintien de maxima pour maintenir une tension maximale précédente d'un signal (A) provenant du premier capteur analogique (10) ;
- un premier moyen de maintien de minima pour maintenir une tension minimale précédente d'un signal (A) provenant du premier capteur analogique (10) ;
- des premiers moyens générateurs de seuil pour produire deux tensions de seuil pour la valeur moyenne des tensions maximale et minimale précédentes du premier capteur analogique (10) plus 38 pour cent de la différence entre cette valeur moyenne et la tension maximale précédente du premier capteur analogique, et pour cette valeur moyenne moins 38 pour cent de la différence entre cette valeur moyenne et la tension minimale précédente du premier capteur analogique ;

- un premier moyen de comparaison de tension pour comparer le signal (A) provenant du premier capteur analogique (10) avec les deux tensions de seuil afin de produire des transitions de sortie à 22.5, 157.5, 202.5 et 337.5 degrés électriques ;

- un second moyen de maintien de maxima pour maintenir une tension maximale précédente d'un signal (B) provenant du second capteur analogique (12) ;

- un second moyen de maintien de minima pour maintenir une tension minimale précédente d'un signal (B) provenant du second capteur analogique (12) ;

- des seconds moyens générateurs de seuil pour produire deux tensions de seuil pour la valeur moyenne des tensions maximale et minimale précédentes du second capteur analogique (12) plus 38 pour cent de la différence entre cette valeur moyenne et la tension maximale précédente du second capteur analogique, et pour cette valeur moyenne moins 38 pour cent de la différence entre cette valeur moyenne du second capteur analogique ;

- un second moyen de comparaison de tension pour comparer le signal (B) provenant du second capteur analogique (12) avec les deux tensions de seuil afin de produire des transitions de sortie à 67.5, 112.5, 247.5 et 292.5 degrés électriques ; et

- un moyen de combinaison pour combiner les transitions de sortie du premier et du second moyens de comparaison de tension de telle sorte qu'un signal de sortie soit produit pour des transitions de sortie à 22.5, 67.5, 112.5, 157.5, 202.5, 247.5, 292.5 et 337.5 degrés électriques.

9. Circuit de multiplication de résolution selon l'une des revendications 1 à 8, comprenant en outre un moyen (22) de rétablissement pour produire une décharge des premier et second moyens de maintien de maxima et des premier et second moyens de maintien de minima après que les tensions de seuil ont été engendrées et pour établir de nouvelles tensions maximale et minimale.

## Patentansprüche

1. Interpolationsschaltung, die mit mehreren analogen Sensoren (10, 12) arbeiten kann, welche eine Position haben, die um einen vorgegebenen Wert elektrisch phasenverschoben ist, mit folgenden Merkmalen:

mehrere Maxima-Haltemittel (14, 18), wobei jedes Maxima-Haltemittel zum Halten einer maximalen Spannung dient, die einem Signal vorausgeht, das von dem entsprechenden analogen Sensor stammt;

mehrere Minima-Haltemittel (16, 20), wobei jedes Minima-Haltemittel zum Halten einer minimalen Spannung dient, die einem Signal vorausgeht, das von den entsprechenden analogen Sensor stammt;

Schwellwerterzeugungsmittel (24, 26, 28, 30, 32, 34) zum unabhängigen Erzeugen mehrerer Schwellspannungen ausgehend von den vorhergehenden maximalen und minimalen Spannungen der entsprechenden analogen Sensoren;

Spannungsvergleichermittel (36, 38) zum unabhängigen Vergleichen der Signale, die von den analogen Sensoren (10, 12) stammen, mit den entsprechenden Schwellspannungen, um Ausgangs-Übergangsfolgen zu erzeugen; und Kombinationsmittel (40) zum Kombinieren der Ausgangsübergänge derart, daß jede Ausgangs-Übergangsfolge, die von jeweils einem Sensor kommt, zwischen den Folgen erzeugt wird, die von anderen analogen Sensoren kommen.

2. Interpolationsschaltung nach Anspruch 1, bei der die Position der elektrischen Phasenverschiebung der analogen Sensoren mit dem vorgegebenen Wert eine Funktion der Anzahl der analogen Sensoren ist, wobei die Phasenverschiebung in elektrischen Grad wiedergegeben wird durch:

$$180/N + 180n$$

wobei N die Anzahl der analogen Sensoren wiedergibt, und n eine ganze Zahl oder Null ist.

3. Interpolationsschaltung nach Anspruch 1, bei der die Anzahl der analogen Sensoren drei ist und die vorgegebene Position der elektrischen Phasenverschiebung der analogen Sensoren 60 elektrische Grad beträgt.

4. Interpolationsschaltung nach Anspruch 1, bei der die Anzahl der analogen Sensoren zwei ist und die vorgegebene Position der elektrischen Phasenverschiebung der analogen Sensoren (10 und 12) 90 elektrische Grad beträgt.

5. Interpolationsschaltung nach Anspruch 4, bei der die ersten Schwellwerterzeugungsmittel (24, 26, 28) und die zweiten Schwellwerterzeugungsmittel (30, 32, 34) jeweils durch Teilung der vorgegangenen maximalen bzw. minimalen Spannung des ersten und des zweiten analogen Sensors drei Schwellspannungen erzeugen, wobei eine dem Mittelwert aus den vorangegangenen maximalen und minimalen Spannungen des Signals entspricht, das von dem entsprechenden analogen Sensor kommt, eine liegt auf halbem Weg zwischen diesem Mittelwert und der entsprechenden vorangegangenen maximalen Spannung, und eine liegt auf halben Weg zwischen diesem Mittelwert und der entsprechenden vorangegangenen minimalen Spannung.

6. Interpolationsschaltung nach Anspruch 5, mit

ersten Maxima-Haltemitteln (14) zum Halten einer vorangegangenen maximalen Spannung eines Signals (A), das von dem ersten analogen Sensor (10) kommt;
ersten Minima-Haltemitteln (16) zum Halten einer vorangegangenen mimimalen Spannung des Signals (A), das von dem ersten analogen Sensor (10) kommt;
ersten Schwellwerterzeugungsmitteln (24, 26, 28) zum Erzeugen von drei Schwellspannungen für den Mittelwert der vorangegangenen maximalen und minimalen Spannung des Signals, das von dem ersten analogen Sensor kommt, für einen Wert, der auf halbem Weg zwischen diesem Mittelwert und der vorangegangenen maximalen Spannung liegt, und für einen Wert, der auf halbem Weg zwischen diesem Mittelwert und der vorangegangenen minimalen Spannung liegt;
ersten Spannungsvergleichermitteln (36) zum Vergleichen des Signals (A), das von dem ersten analogen Sensor (10) kommt, mit den drei Schwellspannungen, um Ausgangsübergänge fiir 0, 30, 150, 180, 210 und 330 elektrische Grad zu bilden;
zweiten Maxima-Haltemitteln (18) zum Halten einer vorangegangenen maximalen Spannung eines Signals (B), das von dem zweiten analogen Sensor (12) kommt;
zweiten Minima-Haltemitteln (20) zum Halten einer vorangegangenen mimimalen Spannung des Signals (B), das von dem zweiten analogen Sensor (12) kommt;
zweiten Schwellwerterzeugungsmitteln (30, 32, 34) zum Erzeugen von drei Schwellspannungen fiir den Mittelwert der vorangegangen maximalen und minimalen Spannung des zweiten analogen Sensors, für einen Wert, der auf halbem Weg zwischen diesem Mittelwert und der vorangegangenen maximalen Spannung liegt, und für einen Wert, der auf halbem Weg zwischen diesem Mittelwert und der vorangegegangenen minimalen Spannung liegt;
zweiten Spannungsvergleichermitteln (38) zum Vergleichen des Signals (B), das von dem zweiten analogen Sensor (12) kommt, mit den drei Schwellspannungen, um Ausgangsübergänge für 60, 90, 120, 240, 270 und 300 elektrische Grad zu bilden; und
Kombinationsmitteln zum Kombinieren der Ausgangsübergänge der ersten (36) und zweiten (38) Spannungsvergleichermitteln derart, daß ein Ausgangssignal mit den Ausgangsübergängen für 0, 30, 60, 90, 120, 150, 180, 210, 240, 270, 300 und 330 elektrische Grand erzeugt wird.

7. Interpolationsschaltung nach Anspruch 4, bei der die Schwellwerterzeugungsmittel jeweils zwei Schwellspannungen erzeugen, wobei eine dem Mittelwert der vorangegangenen maximalen und minimalen Spannung des Signals, das von dem entsprechenden analogen Sensor kommt, plus 38 % der Differenz zwischen diesem Mittelwert und der entsprechenden vorangegangenen maximalen Spannung entspricht, und das andere entspricht diesem Mittelwert minus 38 % der Differenz zwischen diesem Mittelwert und der entsprechenden vorangegangenen minimalen Spannung.

8. Interpolationsschaltung nach Anspruch 7, mit

ersten Maxima-Haltemitteln zum Halten einer vorangegangenen maximalen Spannung eines Signals (A), das von dem ersten analogen Sensor (10) kommt;
ersten Minima-Haltemitteln zum Halten einer vorangegangenen mimimalen Spannung des Signals (A), das von dem ersten analogen Sensor (10) kommt;
ersten Schwellwerterzeugungsmitteln zum Erzeugen von zwei Schwellspannungen für den Mittelwert der vorangegangenen maximalen und minimalen Spannung des analogen Sensors (10) plus 38 % der Differenz zwischen diesem Mittelwert und der vorangegangenen maximalen Spannung des ersten analogen Sensors und für diesen Mittelwert minus 38 % der Differenz zwischen diesem Mittelwert und der vorangegangenen minimalen Spannung des ersten analogen Sensors;
ersten Spannungsvergleichermitteln zum Vergleichen des Signals (A), das von dem ersten analogen Sensor (10) kommt, mit den zwei Schwellspannungen, um Ausgangsübergänge für 22,5, 157,5, 202,5 und 337,5 elektrische Grad zu bilden;
zweiten Maxima-Haltemitteln zum Halten einer vorangegangenen maximalen Spannung eines Signals (B), das von dem zweiten analogen Sensor (12) kommt;

zweiten Minima-Haltemitteln zum Halten einer vorangegangenen mimimalen Spannung des Signals (B), das von dem zweiten analogen Sensor (12) kommt;

zweiten Schwellwerterzeugungsmitteln zum Erzeugen von zwei Schwellspannungen fiir den Mittelwert der vorangegangen maximalen und minimalen Spannung des zweiten analogen Sensors (12) plus 38 % der Differenz zwischen diesem Mittelwert und der vorangegangenen maximalen Spannung des zweiten ananlogen Sensors und fiir diesen Mittelwert minus 38 % der Differenz zwischen diesem Mittelwert und der vorangegangenen minimalen Spannung des zweiten analogen Sensors;

zweiten Spannungsvergleichermitteln (38) zum Vergleichen des Signals (B), das von dem zweiten analogen Sensor (12) kommt, mit den zwei Schwellspannungen, um Ausgangsübergänge für 67,5, 112,5, 277,5 und 292,5 elektrische Grad zu bilden; und

Kombinationsmittel zum Kombinieren der Ausgangsübergänge der ersten und zweiten Spannungsvergleichermittel derart, daß ein Ausgangssignal mit den Ausgangsübergängen fiir 22,5, 67,5, 112,5, 157,5, 202,5, 247,5, 292,5 und 337,5 elektrische Grand erzeugt wird.

9. Interpolationsschaltung nach einem der Ansprüche 1 bis 8 mit Wiederherstellungsmitteln (22) zum Erzeugen einer Entladung der ersten und zweiten Maxima-Haltmittel und der ersten und zweiten Minima-Haltmittel nach der Erzeugung der Schwellspannungen und zum Einrichten neuer maximaler und minimaler Spannungen.

**Claims**

1. A resolution multiplier circuit which can be used with a plurality of analogue sensors (10, 12) having a position of electrical angular displacement of a predetermined value, the circuit comprising:

   - a plurality of means (14, 18) for holding maxima, each maxima-holding means being used to hold a previous maximum voltage of a signal from the respective analogue sensor;
   - a plurality of means (16, 20) for holding minima, each minima-holding means being used to hold a previous minimum voltage of a signal from the respective analogue sensor;
   - threshold-generator means (24, 26, 28, 30, 32, 34) to produce independently a plurality of threshold voltages on the basis of the previous maximum and minimum voltages of the respective analogue sensors;

   - voltage-comparing means (36, 38) for comparing independently the signals from the analogue sensors (10, 12) with the respective threshold voltages in order to produce output transition sequences; and
   - combining means (40) for combining the output transitions in such a way that each output transition sequence from each analogue sensor occurs between the sequences from the other analogue sensors.

2. A resolution multiplier circuit as claimed in claim 1, in which the predetermined value of the position of electrical angular displacement of the analogue sensors depends on the number of analogue sensors, the angular displacement in electrical degrees being represented by :

$$180/N + 180n$$

where N denotes the number of analogue sensors and n is a whole number or zero.

3. A resolution multiplier circuit as claimed in claim 1, in which there are three analogue sensors and the predetermined position of electrical angular displacement of the analogue sensors is 60 electrical degrees.

4. A resolution multiplier circuit as claimed in claim 1, in which there are two analogue sensors and the predetermined position of electrical angular displacement of the analogue sensors (10 and 12) is 90 electrical degrees.

5. A resolution multiplier circuit as claimed in claim 4, in which the first means (24, 26 and 28) and the second means (30, 32 and 34) for generating a threshold each produce three threshold voltages by dividing the previous maximum and minimum voltages of the first and the second analogue sensors respectively, one of which corresponds to the mean value of the previous maximum and minimum voltages of the signal from the respective analogue sensor, one of which is located mid-way between said mean value and the respective previous maximum voltage and one of which is located mid-way between said mean value and the respective previous minimum voltage.

6. A resolution multiplier circuit as claimed in claim 5, comprising:

   - a first means (14) for holding maxima in order to hold a previous maximum voltage of a signal (A) from the first analogue sensor (10);

- a first means (16) for holding minima in order to hold a previous minimum voltage of the signal (A) from the first analogue sensor (10);
- first threshold-generating means (24, 26, 28) for producing three threshold voltages for the mean value of the previous maximum and minimum voltages of the signal from the first analogue sensor, for a value located mid-way between this mean value and the previous maximum voltage and for a value located mid-way between this mean value and the previous minimum voltage;
- a first voltage-comparing means (36) for comparing the signal (A) from the first analogue sensor (10) with the three threshold voltages in order to produce output transitions for 0, 30, 150, 180, 210 and 330 electrical degrees;
- a second means (18) for holding maxima in order to hold a previous maximum voltage of a signal (B) from the second analogue sensor (12);
- a second means (20) for holding minima in order to hold a previous minimum voltage of the signal (B) from the second sensor (12);
- second threshold-generating means (30, 32, 34) for producing three threshold voltages respectively for the mean value of the previous maximum and minimum voltages of the second analogue sensor, for a value located mid-way between said mean value and the previous maximum voltage and for a value located mid-way between said mean value and the previous minimum voltage;
- a second voltage-comparing means (38) for comparing the signal (B) from the second analogue sensor (12) with the three threshold voltages in order to produce output transitions for 60, 90, 120, 240, 270 and 300 electrical degrees; and
- combining means for combining the output transitions of the first (36) and the second (38) voltage comparing-means so that an output signal is produced with output transitions for 0, 30, 60, 90, 120, 150, 180, 210, 240, 270, 300 and 330 electrical degrees.

7. A resolution multiplier circuit as claimed in claim 4, in which the threshold generator means each produce two threshold voltages, one of which corresponds to the mean value of the previous maximum and minimum voltages of the signal from the respective analogue sensor plus 38 per cent of the difference between this mean value and the respective previous maximum voltage and the other of which corresponds to this mean value less 38 per cent of the difference between this mean value and the respective previous minimum voltage.

8. A resolution multiplier circuit as claimed in claim 7, comprising :

- a first means for holding maxima in order to hold a previous maximum voltage of a signal (A) from the first analogue sensor (10);
- a first means for holding minima in order to hold a previous minimum voltage of a signal (A) from the first analogue sensor (10);
- first threshold-generator means to produce two threshold voltages for the mean value of the previous maximum and minimum voltages of the first analogue sensor (10) plus 38 per cent of the difference between this mean value and the previous maximum voltage of the first analogue sensor and for this mean value less 38 per cent of the difference between this mean value and the previous minimum voltage of the first analogue sensor;
- a first voltage-comparing means for comparing the signal (A) from the first analogue sensor (10) with the two threshold voltages in order to produce output transitions at 22.5, 157.5, 202.5 and 337.5 electrical degrees;
- a second means for holding maxima in order to hold a previous maximum voltage of a signal (B) from the second analogue sensor (12);
- a second means for holding minima in order to hold a previous minimum voltage of a signal (B) from the second analogue sensor (12);
- second threshold-generator means to produce two threshold voltages for the mean value of the previous maximum and minimum voltages of the second analogue sensor (12) plus 38 per cent of the difference between this mean value and the previous maximum voltage of the second analogue sensor and for this mean value less 38 per cent of the difference between this mean value and the previous minimum voltage of the second analogue sensor;
- a second voltage-comparing means in order to compare the signal (B) from the second analogue sensor (12) with the two threshold voltages in order to produce output transitions at 67.5, 112.5, 247.5 and 292.5 electrical degrees; and
- a combining means to combine the output transitions of the first and the second voltage-comparison means so that an output signal is produced for the output transitions at 22.5, 67.5, 112.5, 157.5, 202.5, 247.5, 292,5 and 337.5 electrical degrees.

9. A resolution multiplier circuit as claimed in one of claims 1 to 8, having in addition a reestablishing means (22) in order to produce a discharge of the first and second means for holding maxima and the first and second means for holding minima after the threshold voltages have been generated and in order to sestablish new maximum and minimum voltages.

Fig. 1

CAPTEUR HALL 0°

MAINTIEN DE MAXIMUM

MAINTIEN DE MINIMUM

CAPTEUR HALL 90°

MAINTIEN DE MAXIMUM

MAINTIEN DE MINIMUM

LOGIQUE

COMPARATEURS:

1) A & +.5A

2) A & AVG A

3) A & -.5A

COMPARATEURS:

4) B & +.5B

5) B & AVG B

6) B & -.5B

XOR Ckt COMBINAISON DE SIGNAUX

HAUTE RESOLUTION

EP 0 684 455 B1

12

*Fig. 2*

DEUX ONDES SINUSOIDALES
DEPHASEES DE 90°

SIGNAL DE MAINTIEN DE MAXIMUM
(*AVEC RETABLISSEMENT OPTIONNEL*)

SIGNAL DE MAINTIEN DE MINIMUM
(*AVEC RETABLISSEMENT OPTIONNEL*)

SORTIES DES COMPARATEURS

IMPULSIONS DE RETABLISSEMENT DE MAXIMA
(*OPTIONNEL*)

*SORTIE HAUTE RESOLUTION*

EP 0 684 455 B1

Fig. 3

MAXIMUM DE A

MINIMUM DE A

MAXIMUM DE B

MINIMUM DE B

SORTIE

EP 0 684 455 B1